Europäisches Patentamt

**European Patent Office**

**Office européen des brevets**

(11) Publication number: **0 020 054**
**B1**

(12) **EUROPEAN PATENT SPECIFICATION**

(45) Date of publication of patent specification: **28.12.83**

(51) Int. Cl.³: **G 11 C 7/02, G 11 C 17/00**

(21) Application number: **80301583.3**

(22) Date of filing: **14.05.80**

(54) Semiconductor memory device using one transistor memory cell.

(30) Priority: **26.05.79 JP 65349/79**

(43) Date of publication of application:
**10.12.80 Bulletin 80/25**

(45) Publication of the grant of the patent:
**28.12.83 Bulletin 83/52**

(84) Designated Contracting States:
**DE FR GB NL**

(56) References cited:
US - A - 3 648 071
US - A - 3 810 124
US - A - 3 909 808
US - A - 3 962 686
US - A - 4 094 012
US - A - 4 151 603

1977 IEEE INTERNATIONAL SOLID-STATE
CIRCUITS CONFERENCE, February 18, 1977,
New York, USA NEUGEBAUER et al. "Electrically
erasable buried gate PROM", pages 184-185.

(73) Proprietor: **FUJITSU LIMITED**
**1015, Kamikodanaka Nakahara-ku**
**Kawasaki-shi Kanagawa 211 (JP)**

(72) Inventor: **Higuchi, Mitsuo**
**5-13, Yutenji 2-chome Meguro-Ku**
**Tokyo 153 (JP)**
Inventor: **Miyasaka, Kiyoshi**
**577-45 Iijima-cho**
**Totsuka-Ku Yokohama-shi Kanagawa 244 (JP)**

(74) Representative: **Rackham, Stephen Neil et al,**
**GILL JENNINGS & EVERY 53-64 Chancery Lane**
**London WC2A 1HN (GB)**

(56) References cited:
SALSBURY et al. "High performance MOS
EPROM'S using a stacked gate cell", pages 186-
187
IBM TECHNICAL DISCLOSURE BULLETIN, vol.
20, no. 8, January 1978, Armonk, USA BULA et
al. "Substrate voltage transient reduction
circuit", pages 3214-3215

Courier Press, Leamington Spa, England.

IBM TECHNICAL DISCLOSURE BULLETIN, vol.
21, no. 6, November 1978, Armonk, USA
GLADSTEIN et al. "Elimination of bit line
charging through a thick oxide FET read-only
storage device", pages 2593-2594
IEEE JOURNAL OF SOLID-STATE CIRCUITS, vol.
SC-12, no. 5, October 1977, New York, USA
MULLER et al. "An 8192-bit electrically alterable
ROM employing a one-transistor cell with
floating gate", pages 507-514
ELECTRONICS, July 6, 1978, vol. 51, no. 14,
New York, USA RAMACHANDRAN: "Single-
supply erasable PROM saves power with C-MOS
process", pages 106-111

# Semiconductor memory device using one transistor memory cell

The present invention relates to a semiconductor memory device, and more particularly, an integrated circuit semiconductor memory device, such as an erasable programmable read only memory of the ROM or EPROM type device including MOS type semiconductors or floating gate avalanche injection metal oxide type (FAMOS) semiconductors.

The characteristics of a prior art EPROM device are disclosed in the article "16 K Bit Ultraviolet Ray Irradiation Erasure Type EPROM", by Kanichi Harima et al, in Mitsubishi Denki Giho, Volume 53, No. 7 1979, pages 487 to 490.

A semiconductor memory device having an array of FET cells which form a ROM is described in the IEEE Journal of Solid-State Circuits, Volume SC-12, No 5, October 1977, pages 507—514. This illustrates the use of transistors to clamp the bit lines of an FET ROM to a reference potential during certain phases of operation of the memory.

The present invention overcomes the disadvantages inherent in this type of prior semiconductor memory device by reducing the power consumption of the device without reducing the operational speed of the device.

In accordance with the present invention, a semiconductor memory device comprises a plurality of word lines, a plurality of bit lines, and a plurality of transistors each of which forms one cell of the memory and each of which is connected between one of the bit lines and a point at the reference potential, additional transistors being connected between each of the bit lines and the point at the reference potential, and a control circuit being connected to control electrodes of the additional transistors to ensure that the additional transistors are conductive when the semiconductor memory device changes from a non-operative state to an operative state, whereby lowering of the potential of the bit lines during said change is suppressed.

A particular example of a semiconductor memory device in accordance with this invention will now be described and contrasted with the prior art with reference to the accompanying drawings in which:—

Figure 1 is a circuit diagram of a prior art EPROM device of the double gate FAMOS type;

Figure 2 is a series of graphs illustrating the changes of the potentials of the word lines and a bit line in operation of the device;

Figure 3 is a circuit diagram of a semiconductor memory device in accordance with the present invention;

Figure 4 is a circuit diagram of an example of load circuit used in the device of Figure 3; and,

Figure 5 is a series of graphs illustrating the changes of the potentials of the word lines and the bit line of the device shown in Figure 3.

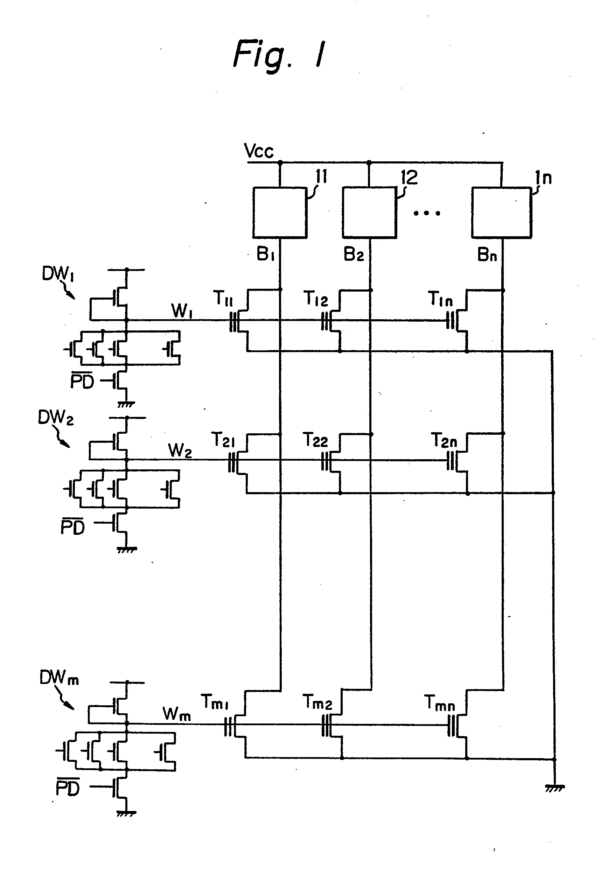

The circuit of a prior art EPROM device of the double gate FAMOS type is illustrated in Fig. 1. Drain electrodes of double gate FAMOS transistors $T_{11}$, $T_{12} \ldots T_{1n}$; $T_{21}$, $T_{22} \ldots T_{2n}$; $\ldots T_{m1}$, $T_{m2} \ldots T_{mn}$ are connected to bit lines $B_1$, $B_2 \ldots B_n$. Gate electrodes of said double gate FAMOS transistors are connected to word lines $W_1$, $W_2 \ldots W_m$ which are controlled by decoders $DW_1$ $DW_2 \ldots DW_m$. Source electrodes of said double gate FAMOS transistors are connected to a point of the reference potential such as ground. Thus, each of said double gate FAMOS transistors constitutes a one-bit cell of the memory device having a memorizing capacity of $m \times n$ bits. Load circuits 11, 12 ... 1n are connected between the bit lines $B_1$, $B_2 \ldots B_n$ and a power source $V_{cc}$. Information in the form of "1" or "0" in the memory device of Fig. 1 can be read out in accordance with the ON state or the OFF state of each of n double gates FAMOS transistors connected to a word line selected from the m word lines.

Since the signal $\overline{PD}$ applied to the decoders are LOW during the non-operative period, in the memory device of Fig. 1, the potentials of the outputs of the decoders connected to the word lines are switched to HIGH and, hence, the potentials of all of the word lines are switched to HIGH during the non-operative period, in order to reduce the power consumption.

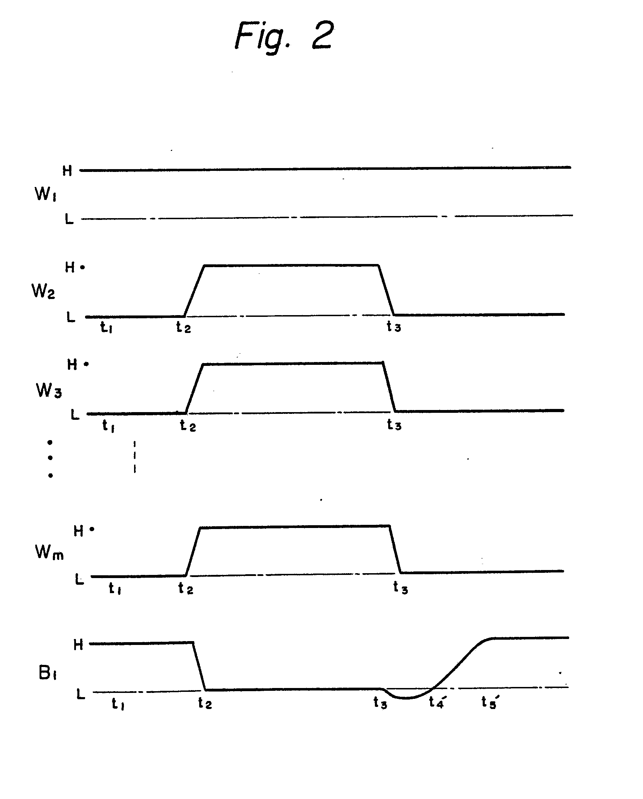

The changes of the potentials of the word lines $w_1$ and $w_2$ through $w_m$ and the bit line $B_1$ are illustrated in Fig. 2. It is assumed that the word line $w_1$ is selected during the period $t_1$ to $t_2$ and the above described reduction of power consumption is effected during the period $t_2$ to $t_3$. The potential of the bit line $B_1$ is HIGH during the period $t_1$ to $t_2$ if the cell transistor selected by the potential of the word line $w_1$ is in the OFF state. During the period $t_2$ to $t_3$, in which the reduction of power consumption is effected, the potentials of the non-selected word lines $w_2$ through $w_m$ are made HIGH, and the potential of the bit line $B_1$ is made LOW, if at least one cell connected to the bit line becomes ON state. The memory device is again rendered operative after the power reduction period $t_2$ to $t_3$ is over. The potential of selected word line $w_1$ remains HIGH and the potentials of non-selected word lines $w_2$ through $w_m$ fall to a LOW level.

However, the potential of the bit line $B_1$, which has been kept LOW during the period $t_2$ through $t_3$, cannot directly switch to a HIGH level. If only a few of the cells in ON state are connected to the bit line, after $t_3$, the potential of the bit line $B_1$ falls to a much lower level during the period $t_3$ to $t_4'$. This is because a capacitance coupling exists due to the parasitic capacitance between the drain electrode of the cell transistor connected to the bit line and the gate electrode connected to the word line of the cell transistor; if a greater number of cells in ON state are connected to the bit line, the potential of the bit line is clamped by the reference potential through such cells in ON state and accordingly does not fall below the reference potential; accordingly, the potential of the bit line after $t_3$ depends upon the number of cells in ON state connected to the bit line, and; accordingly, the less is the number of cells in ON state, the lower is the potential of the bit line. Thus, a longer time is required to complete the charging of the bit line so as to attain HIGH potential of the bit line, so that the speed of the operation of the memory device is reduced. This reduction of the operation speed is disadvantageous in a semiconductor memory device.

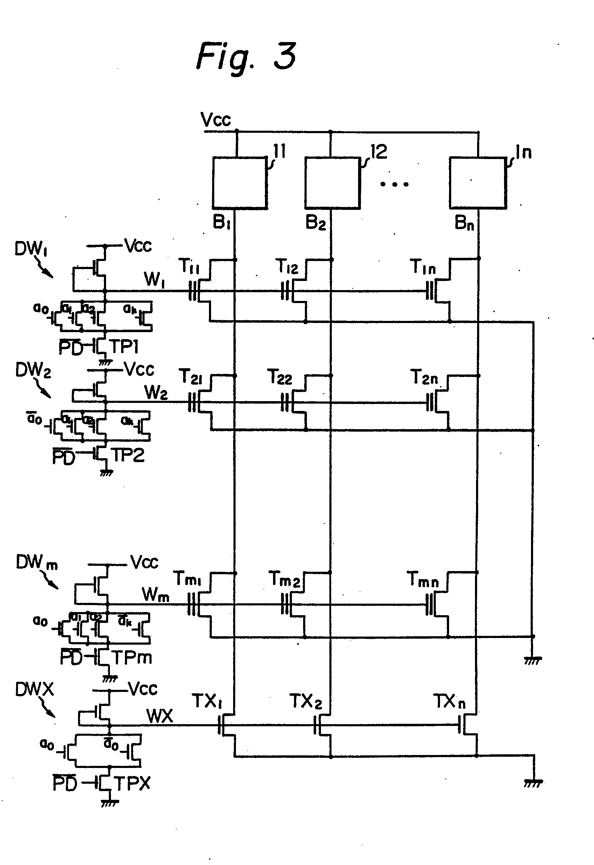

The semiconductor memory device in accordance with the present invention is illustrated in Fig. 3. The device of Fig. 3, includes an array of transistors $TX_1$, $TX_2$ ... $TX_n$ for suppressing the change of the potential of the bit lines inserted between the bit lines and ground. The conductance of each of the added transistors $TX_1$, $TX_2$ ... $TX_n$ is approximately one tenth of the total conductance of all of the cell transistors which are connected to a bit line and turned ON. Except for the addition of this array of transistors $TX_1$, $TX_2$ ... $TX_n$, a word line WX and a decoder DWX for the additional array of transistors, the device of Fig. 3 is the same as the device of Fig. 1. The potential of the word line WX does not become HIGH except for the non-operative period. Such a prevention from being HIGH potential is achieved by the application of the same address signals $a_0$ and $\bar{a}_0$ to the NOR gate portion of the decoder DWX, as illustrated in Fig. 3. The transistors $TX_1$ ... $TX_n$ are rendered conductive when the potential of the word line $W_x$ is "HIGH" and become nonconductive when that potential is "LOW".

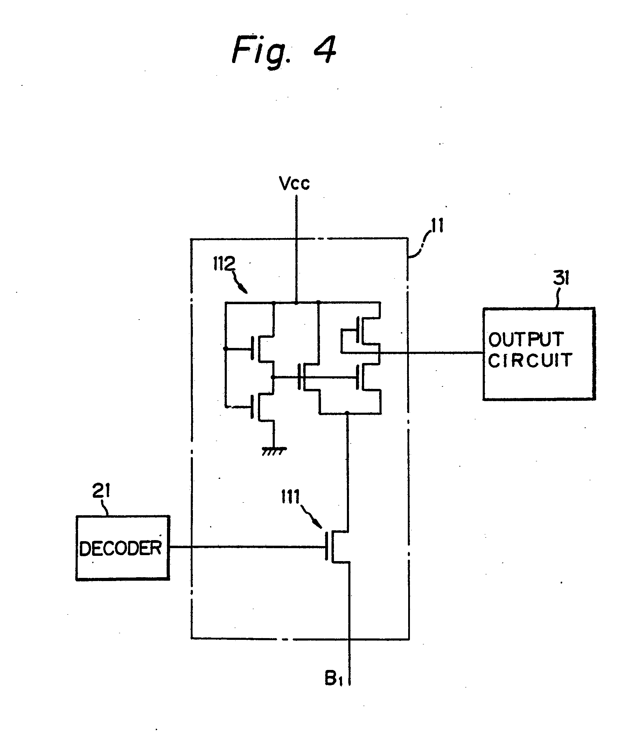

The load circuits 11, 12 ... 1n are connected between the bit lines $B_1$, $B_2$ ... $B_n$ and the power source $V_{cc}$ as in the device of Fig. 1. An example of the load circuit 11 is illustrated in Fig. 4. The load circuit 11 of Fig. 4 comprises a transistor 111 for selecting the bit line $B_1$ which receives a signal from a bit line selecting decoder 21, and a circuit 112 for amplifying the information of the bit line $B_1$ which produces an output signal to an output circuit 31.

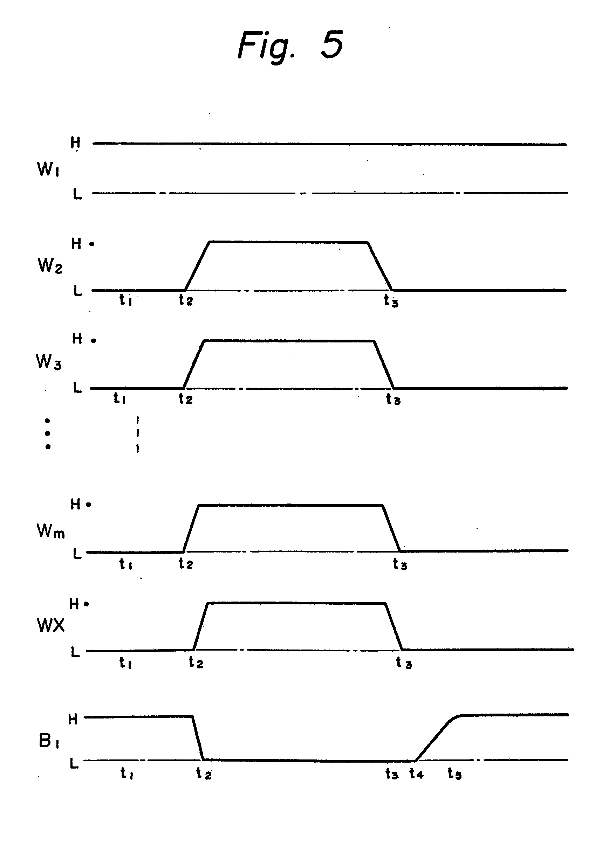

The operation of the device of Fig. 3 will be described hereinafter with reference to Fig. 5, which illustrates the changes of the potentials of the word lines $w_1$ through $w_m$ and the bit line $B_1$. The assumed conditions of the device of Fig. 3 are the same as described hereinbefore with reference to Fig. 2.

During the period $t_1$ through $t_3$, the changes of the potentials of the word lines $w_1$ through $w_m$ and the bit line $B_1$ are the same as in the device of Fig. 1. The potential of the added word line $w_x$ is switched to HIGH during the period $t_2$ through $t_3$, as are the potentials of the word lines $w_2$ through $w_m$. After the period $t_2$ through $t_3$, the potential of the added word line $w_x$ is caused to be LOW approximately simultaneously with the fall of the potentials of the word lines $w_2$ through $w_m$. Thus, during the period $t_3$ through $t_4$, the bit lines $B_1$, $B_2$ ... $B_n$ are supplied with currents through the added transistors $TX_1$, $TX_2$ ... $TX_n$, and accordingly, the potentials of the bit lines $B_1$, $B_2$ ... $B_n$ are unfailingly maintained equal to the level L. Accordingly, after the charging of the bit line $B_1$ starts at $t_4$ through the load circuit 11, the potential of the bit line $B_1$ reaches a HIGH level at $t_5$, which is earlier than $t_5'$ in Fig. 2. For example, in the case where only a few number of cells in ON state are connected to the bit line $B_1$, if the period $t_3$ through $t_4'$ is approximately 300 ns, the period $t_3$ through $t_4$ is approximately 100 ns, so that the time $t_5$ is 200 ns earlier than the time $t_5'$. Thus, the speed of the charging of the bit line $B_1$ is increased and, accordingly, the speed of the operation of the device of Fig. 3 is increased compared with that of the device of Fig. 1.

Although a preferred embodiment of the present invention has been described hereinbefore, various modifications of the structure of the device are possible. For example, the type of transistors used in the device of Fig. 3 is not limited to FAMOS, and other types of transistors, such as ordinary MOS transistors or bipolar transistors, may be used. Also, the type of memory devices used in the device of Fig. 3 is not limited to EPROM, and ordinary ROMs may be used.

**Claims**

1. A semiconductor memory device comprising a plurality of word lines (W1, W2, ... , Wm), a plurality of bit lines (B1, B2, ... , Bn), and a plurality of transistors (T11, Tmn) each of which forms one cell of the memory and each of which is connected between one of the bit lines and a point at the reference potential, additional transistors (TX1, TX2, ... , TXn) being connected between each of the bit lines (B1, B2, ... , Bn) and the point at the reference potential, and a control circuit (DW$_x$) being connected to control electrodes of the additional transistors to ensure that the additional transistors are conductive when the semiconductor memory device changes from a non-operative state to an operative state, whereby lowering of the potential of the bit lines during said change is suppressed.

2. A semiconductor memory device as claimed in claim 1, further comprising a decoder (DW1, ... , DWm) connected to each of the word lines, and a load (11, ... , 1n) connected between each of the bit lines and a power supply, and wherein said plurality of transistors consists of MOSFETs, each of which has its gate connected to one of the word lines, and said control circuit comprises an additional decoder (DWx) arranged to receive both the address signal ($a_0$) and the logical complement ($\bar{a}_0$) of the address signal, such that the lowering of the potential of the bit lines below that of the reference source is suppressed by the additional transistors at least when the memory device changes from its non-operative to its operative state.

## Patentansprüche

1. Halbleiterspeichervorrichtung mit einer Anzahl von Wortleitungen (W1, W2, ..., Wm), einer Anzahl von Bitleitungen (B1, B2, mmm, Bn) und einer Anzahl von Transistoren (T11, Tmn), von denen jeder eine Zelle des Speichers bildet und jeder zwischen einer der Bitleitungen und einem Punkt mit Referenzpotential geschaltet ist, mit zusätzlichen Transistoren (TX1, TX2, ..., TXn), welche zwischen jeder der Bitleitungen (B1, B2, ..., Bn) und dem Punkt mit Referenzpotential geschaltet ist, und mit einer Steuerschaltung ($DW_x$), welche so geschaltet ist, daß sie die Elektroden der zusätzlichen Transistoren steuert, um zu gewährleisten, daß die zusätzlichen Transistoren leitend sind, wenn die Halbleiterspeichervorrichtung von einem Nichtbetriebszustand in einen Betriebszustand wechselt, wodurch eine Erniedrigung des Potentials der Bitleitungen während des Wechsels unterdrückt wird.

2. Halbleiterspeichervorrichtung nach Anspruch 1, mit einem Decoder (DW1, ..., DWm), welcher mit jeder der Wortleitungen verbunden ist, und einer Last (11, ..., 1n), welche zwischen jeder der Bitleitungen und einer Energieversorgung geschaltet ist, und bei welcher die genannte Anzahl von Transistoren aus MOS-Feldeffekttrunsistoren besteht, deren Gateelektrode jeweils mit einer der Wortleitungen verbunden ist, und bei welcher die genannte Steuerschaltung einen zusätzlichen Decoder ($DW_x$) umfaßt, welcher so angeordnet ist, daß er das Adressensignal ($a_o$) und das logische Komplement ($\bar{a}_o$) des Adressensignals empfängt, so daß der Abfall des Potentials der Bitleitungen unterhalb desjenigen der Referenzquelle durch die zusätzlichen Transistoren zumindest dann unterdrückt wird, wenn die Speichervorrichtung von ihrem Nichtbetriebszustand in ihren Betriebszustand wechselt.

## Revendications

1. Dispositif à mémoire à semi-conducteurs, comprenant plusieurs lignes de mots (W1, W2 ... Wm), plusieurs lignes de bits (B1, B2, mmm, Bn) et plusieurs transistors (T11, Tmn), formant chacun une cellule de la mémoire et connectés chacun entre l'une des lignes de bits et un point au potentiel de référence, des transistors supplémentaires (TX1, TX2 ... TXn) étant connectés entre chacune des lignes de bits (B1, B2 ... Bn) et le point au potentiel de référence et un circuit de commande ($DW_x$) étant connecté aux électrodes de commande des transistors supplémentaires pour assurer que les transistors supplémentaires sont conducteurs quand le dispositif de mémoire semi-conducteurs passe d'un état de non fonctionnement à un état de fonctionnement, de manière que l'abaissement du potentiel des lignes de bits pendant ledit changement soit supprimé.

2. Dispositif à mémoire à semi-conducteurs selon la revendication 1, comprenant en outre un décodeur ($DW_1 ... DWm$) connecté à chacune des lignes de mots et une charge (11 ... 1n) connectée entre chacune des lignes de bits et une source d'alimentation, et dans lequel lesdits plusieurs transistors consistent en des MOS FET, ayant chacun la grille connectée à l'une des lignes de mots, et ledit circuit de commande comprenant un décodeur supplémentaire ($DW_x$) agencé pour recevoir à la fois le signal d'adresse ($a_o$) et le complément logique ($\bar{a}_o$) du signal d'adresse, de manière que l'abaissement du potentiel des lignes de bits au-dessous de celui de la source de référence soit supprimé par les transistors supplémentaires au moins quand le dispositif à mémoire passe de son état de non fonctionnement à son état de fonctionnement.

# Fig. 1

# Fig. 2

# Fig. 3

# Fig. 4

Vcc

11

112

31

OUTPUT CIRCUIT

21

DECODER

111

B₁

Fig. 5